(19)

**Europäisches Patentamt**
**European Patent Office**
**Office européen des brevets**

(11) **EP 3 706 167 A1**

(12) **EUROPEAN PATENT APPLICATION**

(43) Date of publication:
**09.09.2020 Bulletin 2020/37**

(51) Int Cl.:
**H01L 27/11507** (2017.01)    **H01L 49/02** (2006.01)
**H01G 4/005** (2006.01)    **H01G 4/33** (2006.01)

(21) Application number: **20153095.3**

(22) Date of filing: **22.01.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **06.03.2019 US 201916294811**

(71) Applicant: **INTEL Corporation**
**Santa Clara, CA 95054 (US)**

(72) Inventors:
• **LIN, Chia-Ching**
**Portland, OR 97229 (US)**
• **CHANG, Sou-Chi**
**Portland, OR 97229 (US)**

• **PENUMATCHA, Ashish Verma**
**Hillsboro, OR 97124 (US)**
• **HARATIPOUR, Nazila**
**Hillsboro, OR 97124 (US)**
• **SUNG, Seung Hoon**
**Portland, OR 97229 (US)**
• **LOH, Owen Y.**
**Portland, OR 97221 (US)**
• **KAVALIEROS, Jack**
**Portland, OR 97229 (US)**
• **AVCI, Uygar E.**
**Portland, OR 97225 (US)**
• **YOUNG, Ian A.**
**Portland, OR 97229 (US)**

(74) Representative: **Goddar, Heinz J.**
**Boehmert & Boehmert**
**Anwaltspartnerschaft mbB**
**Pettenkoferstrasse 22**
**80336 München (DE)**

(54) **CAPACITOR WITH EPITAXIAL STRAIN ENGINEERING**

(57)    Described is a ferroelectric based capacitor that reduces non-polar monoclinic phase and increases polar orthorhombic phase by epitaxial strain engineering in the oxide thin film and/or electrodes. As such, both memory window and reliability are improved. The capacitor comprises: a first structure comprising metal, wherein the first structure has a first lattice constant; a second structure comprising metal, wherein the second structure has a second lattice constant; and a third structure comprising ferroelectric material (e.g., oxide of Hf or Zr), wherein the third structure is between and adjacent to the first and second structures, wherein the third structure has a third lattice constant, and wherein the first and second lattice constants are smaller than the third lattice constant.

Fig. 5

**EP 3 706 167 A1**

**Description**

## BACKGROUND

Devices such as high charge capacity capacitors (e.g., metal-insulator-metal (MIM) capacitors) for backend can be formed as passive circuit elements or transistors (e.g., metal-oxide-semiconductor (MOS) transistors) for frontend as active circuit elements. Passive circuit elements can be used to provide charge storage and sharing, while active circuit elements can be used to enable low voltage and high current power supply. Thin-film capacitors enable low-voltage operation. However, traditional thin-film ferroelectric capacitors have low retention and also weak polarization due to strong depolarization. New materials and stack design are desired to enable ferroelectric capacitors with longer retentions and high charge density.

The background description provided here is for the purpose of generally presenting the context of the disclosure. Unless otherwise indicated here, the material described in this section is not prior art to the claims in this application and are not admitted to be prior art by inclusion in this section.

## BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.

**Fig. 1A** illustrates a schematic of a ferroelectric capacitor (FE-Cap).
**Fig. 1B** illustrates a plot showing charge versus voltage function of the FE-Cap, its memory states, and imprint charge.
**Fig. 1C** illustrates a plot showing hysteresis property of ferroelectric material, in accordance with some embodiments.
**Fig. 2** illustrates a plot showing epitaxial strain for a FE material (e.g., $ZrO2$).
**Fig. 3** illustrates a cross-section of a capacitor over bit-line (COB) with lattice mismatch between ferroelectric material and metal electrodes, in accordance with some embodiments of the disclosure.
**Fig. 4** illustrates a cross-section of a metal-insulator-metal (MIM) capacitor with lattice mismatch between ferroelectric material and metal electrodes, in accordance with some embodiments of the disclosure.
**Fig. 5** illustrates a cross-section of an embedded dynamic random access memory (eDRAM) comprising COB with lattice mismatch between ferroelectric material and metal electrodes, in accordance with some embodiments of the disclosure.
**Fig. 6** illustrates a cross-section of a backend stack having a capacitor with lattice mismatch between ferroelectric material and metal electrodes, according to some embodiments of the disclosure.
**Fig. 7** illustrates a cross-section of an FE capacitor with lattice mismatch between ferroelectric material and metal electrodes, according to some embodiments of the disclosure.
**Fig. 8** illustrates an apparatus, which includes a power plane comprising a super capacitor with lattice mismatch between ferroelectric material and metal electrodes, according to some embodiments of the disclosure.
**Fig. 9** illustrates an apparatus showing distributed metal-insulator-metal (MIM) capacitors comprising super capacitors with lattice mismatch between ferroelectric material and metal electrodes, according to some embodiments of the disclosure.
**Figs. 10A-B** illustrate apparatuses and for switch mode power supply during charging and discharging modes, respectively, according to some embodiments of the disclosure.
**Fig. 11** illustrates a 4-terminal controlled switch for the power plane, according to some embodiments of the disclosure.
**Fig. 12** illustrates a flowchart for forming an FE capacitor with lattice mismatch between ferroelectric material and metal electrodes, in accordance with some embodiments of the disclosure, in accordance with some embodiments.
**Fig. 13** illustrates a smart device, a computer system, or a SoC (System-on-Chip) including capacitor with lattice mismatch between ferroelectric material and metal electrodes, in accordance with some embodiments of the disclosure.

## DETAILED DESCRIPTION

Hafnium (Hf) and Zirconium (Zr) based ferroelectric oxide thin films are promising options for the next generation of front-end or back-end embedded dynamic random access memory (DRAM), high-density memory, and metal-insulator-metal (MIM) capacitor due to their scalability. However, the most stable phase (i.e., the lowest energy configuration in the energy landscape) of Hf and Zr -based oxide is the monoclinic phase which is a non-polar phase. If the ratio of monoclinic phase in oxide is increased, the memory window will be lower. Also, for long endurance cycles, polar orthorhombic phase gradually changes to monoclinic phase due to electric field cycling, which is a reliability issue for the ferroelectric oxide.

One way to improve reliability of the ferroelectric oxide is to use different doping, thickness, annealing methods, interface treatments, and Atomic Layer Deposition (ALD) deposition sequences. However, such methods show little improvement to memory window and reliability. The challenge of achieving higher endurance cycles (e.g., greater than $10^{12}$) at high temperatures (e.g., over 80 degree Celsius) for existing ferroelectric based capacitors remains real.

In some embodiments, non-polar monoclinic phase is reduced and polar orthorhombic phase is increased by epitaxial strain engineering in the ferroelectric oxide thin film and/or electrodes. In some embodiments, a ferroelectric capacitor is fabricated which comprises: a first structure (e.g., a top electrode) comprising metal, wherein the first structure has a first lattice constant. The capacitor further comprises a second structure (e.g., a bottom electrode) comprising metal, wherein the second structure has a second lattice constant. In some embodiments, the capacitor comprises a third structure including ferroelectric material, wherein the third structure is between and adjacent to the first and second structures, wherein the third structure has a third lattice constant, and wherein the first and second lattice constants are smaller than the third lattice constant. By having the first and second lattice constants smaller than the third lattice constant, strain engineering is achieved that suppresses the non-polar monoclinic phase and increases the orthorhombic phase. Strain engineering dramatically improves the memory window and reliability of the ferroelectric oxide thin film. Other technical effects will be evident from the various embodiments and figures.

In the following description, numerous details are discussed to provide a more thorough explanation of embodiments of the present disclosure. It will be apparent, however, to one skilled in the art, that embodiments of the present disclosure may be practiced without these specific details. In other instances, well-known structures and devices are shown in block diagram form, rather than in detail, in order to avoid obscuring embodiments of the present disclosure.

Note that in the corresponding drawings of the embodiments, signals are represented with lines. Some lines may be thicker, to indicate more constituent signal paths, and/or have arrows at one or more ends, to indicate primary information flow direction. Such indications are not intended to be limiting. Rather, the lines are used in connection with one or more exemplary embodiments to facilitate easier understanding of a circuit or a logical unit. Any represented signal, as dictated by design needs or preferences, may actually comprise one or more signals that may travel in either direction and may be implemented with any suitable type of signal scheme.

The term "device" may generally refer to an apparatus according to the context of the usage of that term. For example, a device may refer to a stack of layers or structures, a single structure or layer, a connection of various structures having active and/or passive elements, etc. Generally, a device is a three-dimensional structure with a plane along the x-y direction and a height along the z direction of an x-y-z Cartesian coordinate system. The plane of the device may also be the plane of an apparatus which comprises the device.

Throughout the specification, and in the claims, the term "connected" means a direct connection, such as electrical, mechanical, or magnetic connection between the things that are connected, without any intermediary devices.

The term "coupled" means a direct or indirect connection, such as a direct electrical, mechanical, or magnetic connection between the things that are connected or an indirect connection, through one or more passive or active intermediary devices.

The term "adjacent" here generally refers to a position of a thing being next to (e.g., immediately next to or close to with one or more things between them) or adjoining another thing (e.g., abutting it).

The term "circuit" or "module" may refer to one or more passive and/or active components that are arranged to cooperate with one another to provide a desired function.

The term "signal" may refer to at least one current signal, voltage signal, magnetic signal, or data/clock signal. The meaning of "a," "an," and "the" include plural references. The meaning of "in" includes "in" and "on."

The term "scaling" generally refers to converting a design (schematic and layout) from one process technology to another process technology and subsequently being reduced in layout area. In some case, scaling to another process technology node also resilts into upsizing devices and their layout. The term "scaling" generally also refers to downsizing layout and devices within the same technology node. The term "scaling" may also refer to adjusting (e.g., slowing down or speeding up - i.e. scaling down, or scaling up respectively) of a signal frequency relative to another parameter, for example, power supply level.

The terms "substantially," "close," "approximately," "near," and "about," generally refer to being within +/- 10% of a target value. For example, unless otherwise specified in the explicit context of their use, the terms "substantially equal," "about equal" and "approximately equal" mean that there is no more than incidental variation between among things so described. In the art, such variation is typically no more than +/-10% of a predetermined target value.

Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

The terms "left," "right," "front," "back," "top," "bottom," "over," "under," and the like in the description and in the claims, if any, are used for descriptive purposes and not necessarily for describing permanent relative positions. For example, the terms "over," "under," "front side," "back side," "top," "bottom," "over," "under," and "on" as used herein refer to a relative position of one component, structure, or material with respect to other referenced components, structures or materials within a device, where such physical relationships are noteworthy. These terms are employed herein for descriptive purposes only and predominantly within the context of a device z-axis and therefore may be relative to an orientation of a device. Hence, a first material "over" a second material in the context of a figure provided herein may also be "under" the second material if the device is oriented upside-down relative to the context of the figure provided. In the context of materials, one material disposed over or under another may be directly in contact or may have one or more intervening materials. Moreover, one material disposed between two materials may be directly in contact with the two layers or may have one or more intervening layers. In contrast, a first material "on" a second material is in direct contact with that second material. Similar distinctions are to be made in the context of component assemblies.

The term "between" may be employed in the context of the z-axis, x-axis or y-axis of a device. A material that is between two other materials may be in contact with one or both of those materials, or it may be separated from both of the other two materials by one or more intervening materials. A material "between" two other materials may therefore be in contact with either of the other two materials, or it may be coupled to the other two materials through an intervening material. A device that is between two other devices may be directly connected to one or both of those devices, or it may be separated from both of the other two devices by one or more intervening devices.

Here, multiple non-silicon semiconductor material layers may be stacked within a single fin structure. The multiple non-silicon semiconductor material layers may include one or more "P-type" layers that are suitable (e.g., offer higher hole mobility than silicon) for P-type transistors. The multiple non-silicon semiconductor material layers may further include one or more "N-type" layers that are suitable (e.g., offer higher electron mobility than silicon) for N-type transistors. The multiple non-silicon semiconductor material layers may further include one or more intervening layers separating the N-type from the P-type layers. The intervening layers may be at least partially sacrificial, for example to allow one or more of a gate, source, or drain to wrap completely around a channel region of one or more of the N-type and P-type transistors. The multiple non-silicon semiconductor material layers may be fabricated, at least in part, with self-aligned techniques such that a stacked CMOS device may include both a high-mobility N-type and P-type transistor with a footprint of a single finFET.

Here, the term "backend" generally refers to a section of a die which is opposite of a "frontend" and where an IC (integrated circuit) package couples to IC die bumps. For example, high level metal layers (e.g., metal layer 6 and above in a ten-metal stack die) and corresponding vias that are closer to a die package are considered part of the backend of the die. Conversely, the term "frontend" generally refers to a section of the die that includes the active region (e.g., where transistors are fabricated) and low-level metal layers and corresponding vias that are closer to the active region (e.g., metal layer 5 and below in the ten-metal stack die example).

It is pointed out that those elements of the figures having the same reference numbers (or names) as the elements of any other figure can operate or function in any manner similar to that described, but are not limited to such.

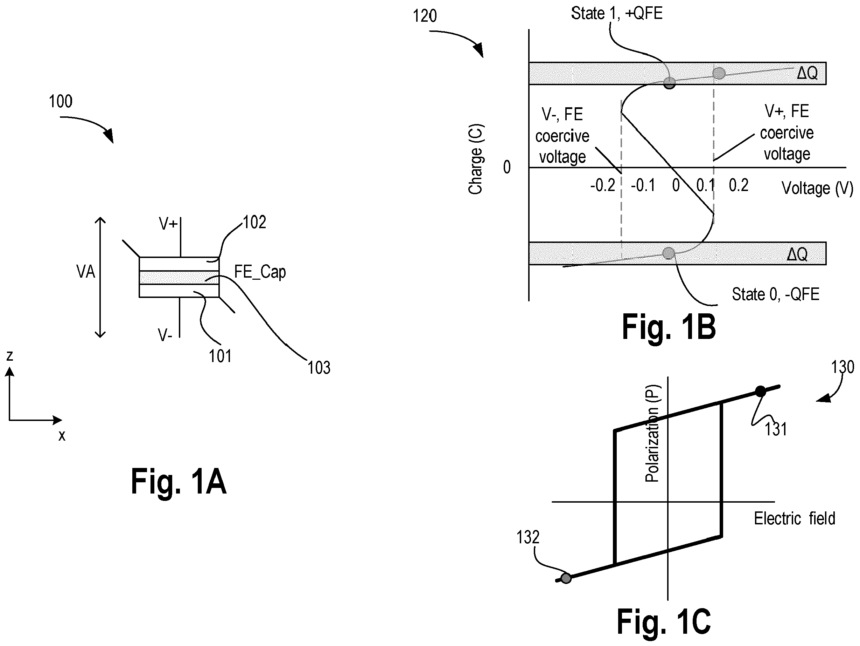

**Fig. 1A** illustrates a schematic of a ferroelectric capacitor (FE-Cap) 100. **Fig. 1B** illustrates plot 120 showing charge versus voltage function of the FE-Cap, its memory states, and imprint charge. FE-cap 100 generally comprises two metal layers 101 and 102 and ferroelectric material 103 coupled between them. Unlike a normal dielectric based capacitor, a ferroelectric capacitor uses polarization charge to store the memory states, where positive and negative polarization charge indicates state "1" or "0". To switch an FE-cap, the applied FE-cap voltage VA is be higher than the ferroelectric coercive voltages (which behave as threshold voltages) when driven by a voltage source. For example, VA is greater than V+ for 0 to 1 state switching, and VA is less than V- for 1 to 0 state switching.

**Fig. 1C** illustrates plot 130 showing hysteresis property of ferroelectric material 103, in accordance with some embodiments. A ferroelectric material exhibits ferroelectricity which is a property by which a spontaneous electric polarization can be revered by an electric field (e.g., applied voltage). When dielectric materials are polarized, the induced polarization 'P' is almost exactly proportional to the applied external electric field E. In such materials, the polarization is a linear function of the applied electric field or voltage. Ferroelectric materials, on the other hand, demonstrate a spontaneous non-zero polarization even when the applied electric field E is zero. As such, the spontaneous polarization can be reversed by an applied electric field in the opposite direction. This results in a hysteresis loop because the polarization of a ferroelectric material is dependent not only on the present electric field but also on its history. The hysteresis loop of plot 130 shows two stable operating positions for FE 103-position 131 and position 132. These two stable positions indicate that the direction of polarization can be switched (e.g., polled) from one to another and this changes the response of polarization to applied AC voltage.

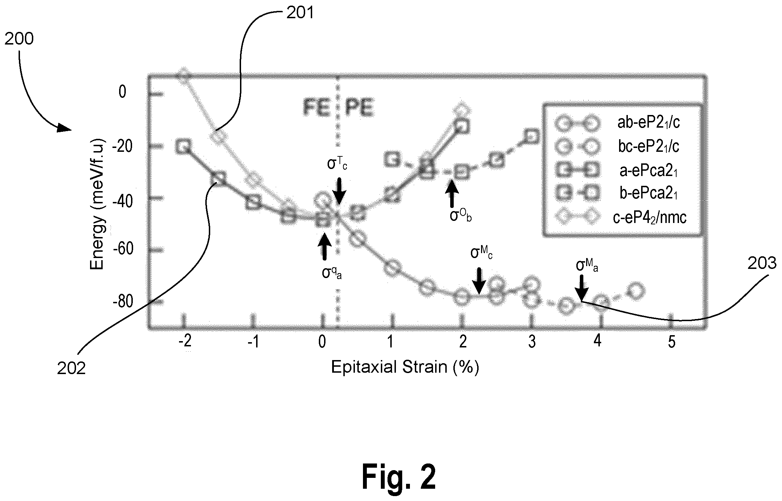

Fig. 2 illustrates plot 200 showing epitaxial strain for a FE material (e.g., ZrO2). Here, the x-axis is epitaxial strain (%) while y-axis is energy. There are 4 phases in Hf and Zr -based thin film oxide. Cubic phase is the high-energy phase. Tetragonal phase (e.g., 201) is the anti-ferroelectric phase. Orthorhombic phase (e.g., 202) is a ferroelectric phase (polar phase). Monoclinic phase (e.g., 203) is the lowest energy and most stable phase, but it is a non-polar phase. To have ferroelectric property memory or MIM capacitor, monoclinic phase 203 is suppressed so get more orthorhombic and tetragonal phases. In some embodiments, monoclinic phase can be suppressed with compressive strain in ferroelectric oxide. In capacitor structure where ferroelectric oxide is between electrodes (e.g., Fig. 1), low memory window is observed with electrodes (101, 102) with tensile strain to ferroelectric oxide 103.

In some embodiments, lattice mismatch is adapted at the interface of electrodes 101, 102 and FE 103 or in the FE oxide film 103 to have compressive strain. There are two approaches to have compressive strain in ferroelectric oxide, in accordance with some embodiments. In one embodiment, doping the elements in FE 103 with a lattice constant smaller than the lattice constant of FE Hf and Zr -based oxide, results in compressive strain in FE 103. Examples of such doping elements include: La, Si, Al, Y, Gd, and Sr. In one embodiment, using materials for electrodes 102 and 101 with lattice constant that is smaller than the lattice constant of FE Hf and Zr -based oxide, results in compressive strain in FE 103. In some embodiments, the desirable compressive strain ranges from 0% to - 1% Hf and Zr -based oxide as shown in **Fig.2.** In some embodiments, the lattice constant of Hf and Zr -based oxide ranges from 5.0 Angstrom (A) to 5.1 A.

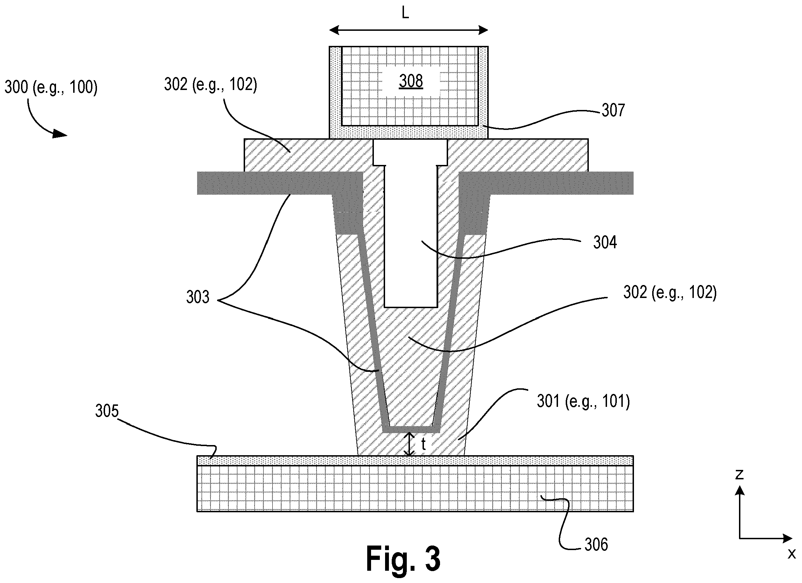

**Fig. 3** illustrates a cross-section of a capacitor over bit-line (COB) 300 with lattice mismatch between ferroelectric material and metal electrodes, in accordance with some embodiments of the disclosure. In some embodiments, COB 300 comprises first electrode 301 (e.g., 101), second electrode 302 (e.g., 102), ferroelectric material 303, metal structure 304, first barrier 305, first interconnect 306, second barrier 307, and second interconnect 308. In COB configurations, in various embodiments, stacked memory capacitors are fabricated above an access transistor in the back-end interconnect portion of the process flow. In some embodiments, first and second electrodes 301 and 302, respectively, comprise any metallic materials that have lattice constant smaller than 5.0A. For example, metallic materials such as TiN, TaN, Mo, Pt, W, Al, Pd, Ag, and/or Au can be used for first and second electrodes 301 and 302, respectively.

In some embodiments, ferroelectric material 303 employed in the ferroelectric capacitor 300 may include, for example, materials exhibiting ferroelectric behavior at thin dimensions (e.g., between 1 nm and 10 nm), such as hafnium or zirconium -based oxide (Hf or Zr -based oxide). In some embodiments, the elements that can be doped into the oxide film are any materials with lattice constant smaller than 5.0A. In various embodiments, FE material 303 has orthorhombic phase. In one embodiment, doping the elements in FE 303 with a material having lattice constant smaller than the lattice constant of FE Hf and Zr - based oxide, results in compressive strain in FE 303. Examples of the doping elements include La, Si, Al, Y, Gd, and Sr. In some embodiments, using materials for electrodes 302 and 301 with lattice constant that is smaller than the lattice constant of FE 303 (e.g., Hf and Zr -based oxide), results in compressive strain in FE 103. In some embodiments, the desirable compressive strain for FE 303 ranges from 0% to -1%. In some embodiments, the lattice constant of FE material 202 (e.g., Hf and Zr -based oxide) ranges from 5.0 A to 5.1 A.

In some embodiments, first and second interconnects 306 and 308 include one or more of: Cu, Al, graphene, CNT, Au, Co, TiN, TaN, W, Ag, Au, or Pt. In some embodiments, barrier layers 305 and 307 are provided between the interconnects and electrodes. In various embodiments, these barriers are diffusion barriers and may comprise TaN or graphene. In some embodiments, these barrier layers 305 and 307 are air-gaps or metal filling. In the case of metal filling, barrier layers 305 and 307 can be same material as 301 and 302, or can be different materials which are metallic such as: W, Cu, Ru, Ag, and/or Pt. The thickness of t of barrier layers 305 and 307 is in a range of 1 nm to 20 nm. In some examples, a traditional COB fabrication process flow can be used to fabricate COB 300.

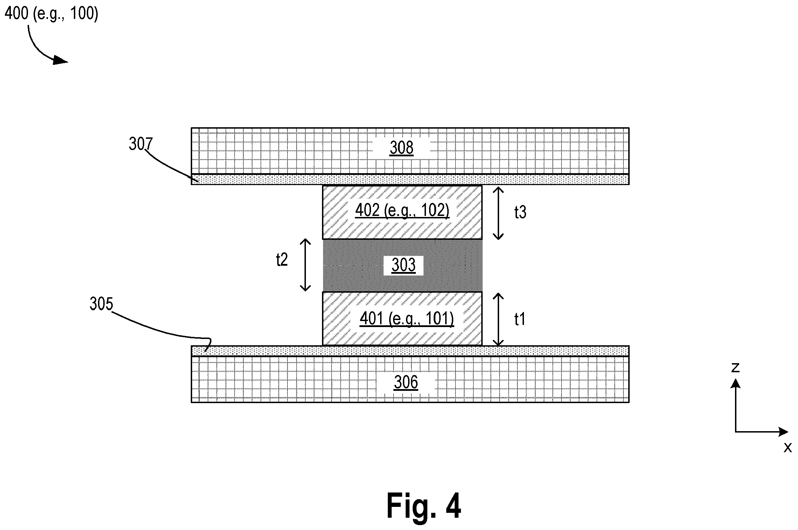

**Fig. 4** illustrates a cross-section of a metal-insulator-metal (MIM) capacitor 400 with lattice mismatch between ferroelectric material and metal electrodes, in accordance with some embodiments of the disclosure. Capacitor 400 has similar material as COB 300. Capacitor 400 comprises first electrode 401 (e.g., 101), second electrode 402 (e.g., 102), ferroelectric material 303, metal structure 304, first barrier 305, first interconnect 306, second barrier 307, and second interconnect 308. Material wise, first and second electrodes 401 and 402, respectively, are similar to materials for first and second electrodes 301 and 302, respectively. Capacitor 400 can be used in the frontend or the backend. In some examples, thicknesses t1 and t3 are in a range of 1 nm to 20 nm, while thickness t2 is in a range of 3 nm and 15 nm.

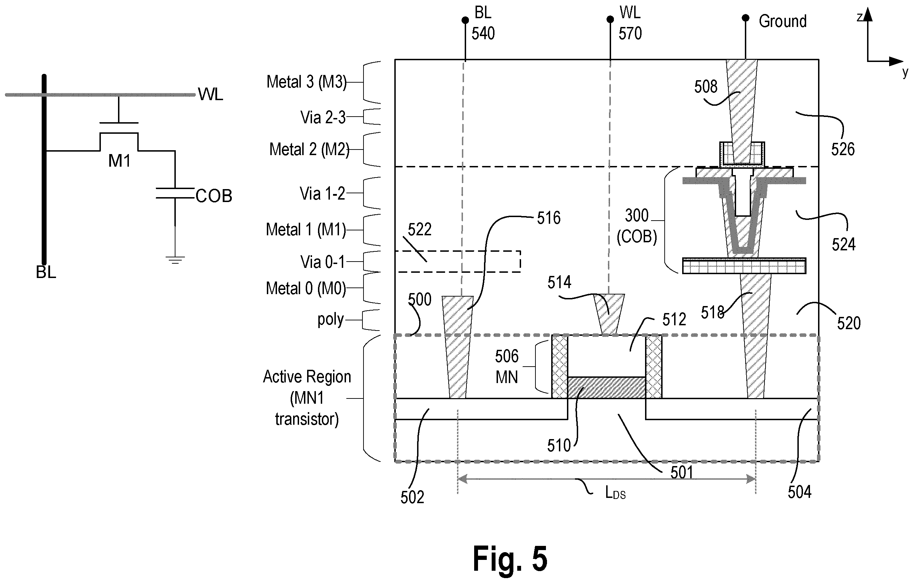

**Fig. 5** illustrates a cross-section of an embedded dynamic random access memory (eDRAM) comprising COB 300 with lattice mismatch between ferroelectric material 303 and metal electrodes 301, 302, in accordance with some embodiments of the disclosure.

In some embodiments, transistor 500 has source region 502, drain region 504 and gate 506. Transistor 500 (e.g., n-type transistor M1) further includes gate contact 514 disposed above and electrically coupled to gate 506, source contact 516 disposed above and electrically coupled to source region 502, and drain contact 518 disposed above and electrically coupled to drain region 504. In various embodiments, COB 300 (or MIM 400) is disposed above the transistor 500 such that electrode 308 is coupled to via or metal structure 508A, and electrode 306 is coupled to via 518.

In some embodiments, gate contact 514 is directly below COB 300 (or MIM 400). In some embodiments, word-line (WL) contact 570 is disposed onto gate contact 514 on a second y-z plane behind (into the page) first y-z plane metal 522a.

In some embodiments, transistor 500 associated with substrate 501 is a metal-oxide-semiconductor field-effect transistor (MOSFET or simply MOS transistors), fabricated on substrate 501. In various embodiments of the present disclosure, transistor 500 may be planar transistors, nonplanar transistors, or a combination of both. Nonplanar transistors include FinFET transistors such as double-gate transistors and tri-gate transistors, and wrap-around or all-around gate transistors such as nanoribbon and nanowire transistors. In an embodiment, transistor 500 is a tri-gate transistor.

Here, COB 300 or MIM 400 stores data. Data is written into COB 300 as charge via bit-line (BL) 540 when access transistor M1 is turned on by applying voltage on word-line WL 570.

In some embodiments, underlying substrate 501 represents a surface used to manufacture integrated circuits. In some embodiments, substrate 501 includes a suitable semiconductor material such as but not limited to, single crystal silicon, polycrystalline silicon and silicon on insulator (SOI). In another embodiment, substrate 501 includes other semiconductor materials such as germanium, silicon germanium, or a suitable group III-V or group III-N compound. Substrate 501 may also include semiconductor materials, metals, dopants, and other materials commonly found in semiconductor substrates.

In some embodiments, transistor 500 includes a gate stack formed of at least two layers, gate dielectric layer 510 and gate electrode layer 512. The gate dielectric layer 510 may include one layer or a stack of layers. The one or more layers may include silicon oxide, silicon dioxide ($SiO_2$) and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer 510 to improve its quality when a high-k material is used.

Gate electrode layer 512 of transistor 500 is formed on gate dielectric layer 510 and may comprise of at least one P-type work-function metal or N-type work-function metal, depending on whether the transistor is to be a PMOS or an NMOS transistor. In some embodiments, gate electrode layer 512 may comprise of a stack of two or more metal layers, where one or more metal layers are work-function metal layers and at least one metal layer is a conductive fill layer.

For a PMOS transistor, metals that may be used for gate electrode layer 512 include, but are not limited to, ruthenium, palladium, platinum, cobalt, nickel, and conductive metal oxides, e.g., ruthenium oxide. A P-type metal layer will enable the formation of a PMOS gate electrode layer 512 with a work-function that is between about 4.9 eV and about 5.2 eV. For an NMOS transistor, metals that may be used for gate electrode layer 512 include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode layer 512 with a work-function that is between about 3.9 eV and about 4.2 eV.

In some embodiments, gate electrode layer 512 may comprise a "U"-shaped structure that includes a bottom portion substantially parallel to the surface of the substrate and two sidewall portions that are substantially perpendicular to the top surface of the substrate. In another embodiment, at least one of the metal layers that form gate electrode layer 512 may simply be a planar layer that is substantially parallel to the top surface of the substrate and does not include sidewall portions substantially perpendicular to the top surface of the substrate. In some embodiments of the present disclosure, gate electrode layer 512 may comprise of a combination of U-shaped structures and planar, non-U-shaped structures. For example, gate electrode layer 512 may comprise of one or more U-shaped metal layers formed atop one or more planar, non-U-shaped layers.

In some embodiments, a pair of gate dielectric layer 510 may be formed on opposing sides of the gate stack that bracket the gate stack. Gate dielectric layer 510 may be formed from a material such as silicon nitride, silicon oxide, silicon carbide, silicon nitride doped with carbon, and silicon oxynitride. Processes for forming sidewall spacers are well known in the art and generally include deposition and etching process operations. In some embodiments, a plurality of spacer pairs may be used, for instance, two pairs, three pairs, or four pairs of sidewall spacers may be formed on opposing sides of the gate stack.

In some embodiments, source region 502 and drain region 504 are formed within the substrate adjacent to the gate stack of transistor 500. Source region 502 and drain region 504 are generally formed using either an implantation/diffusion process or an etching/deposition process. In the former process, dopants such as boron, aluminum, antimony, phosphorous, or arsenic may be ion-implanted into the substrate to form source region 502 and drain region 504. An annealing process that activates the dopants and causes them to diffuse further into the substrate typically follows the ion implantation process. In the latter process, the substrate may first be etched to form recesses at the locations of the source and drain regions. An epitaxial deposition process may then be carried out to fill the recesses with material that is used to fabricate source region 502 and drain region 504. In some embodiments, source region 502 and drain region 504 may be fabricated using a silicon alloy such as silicon germanium or silicon carbide. In some embodiments, the epitaxially deposited silicon alloy may be doped in-situ with dopants such as boron, arsenic, or phosphorous. In some embodiments, source region 502 and drain region 504 may be formed using one or more alternate semiconductor materials such as germanium or a suitable group III-V compound. In some embodiments, one or more layers of metal and/or metal alloys may be used to form source region 502 and drain region 504.

In some embodiments, gate contact 514 and drain contact 518 of the transistor 500 are disposed in first dielectric layer 520 disposed above substrate 501. In some embodiments, terminal B is disposed in second dielectric layer 522 disposed on first dielectric layer 520. In some embodiments, third dielectric layer 524 is disposed on the second dielectric layer 522. In some embodiments, fourth dielectric layer 526 is disposed on the third dielectric layer 524. In some embodiments, source contact 516 is partially disposed in fourth dielectric layer 526, partially disposed in third dielectric layer 524, partially disposed in second dielectric layer 522 and partially disposed on the first dielectric layer 520. In some embodiments, terminal B contact is disposed in the third dielectric layer 524. In some embodiments, the conductive interconnect structure such as conductive interconnect structure 508 disposed in fourth dielectric layer 526.

In the illustrated embodiment of **Fig. 5,** gate contract 514 is formed in poly region; drain contract 518 is formed in active, poly, and Metal 0 (M0); electrode 306 is formed in Via 0-1 layer; COB 300 is formed in Metal 1 (M1) and Via 1-2; electrode 308 is formed in Metal 2 (M2), and conductor 508 is formed in Via 2-3 and Metal (M3). In some embodiments, COB 300 is formed in the metal 3 (M3) region.

In some embodiments, an n-type transistor M1 is formed in the frontend of the die while COB 300 is located in the backend of the die. In some embodiments, COB 300 is located in the backend metal layers or via layers for example in Via 3. In some embodiments, the electrical connectivity to the device is obtained in layers M0 and M4 or M1 and M5 or any set of two parallel interconnects. In some embodiments, COB 300 is formed in metal 2 (M2) and metal 1 (M1) layer region and/or Via 1-2 region.

While the embodiment of **Fig. 5** is illustrated with reference to a frontend transistor M1, eDRAM cell can also be formed entirely in the backend. In some embodiments, access transistor M1 of the eDRAM cell may include a back end transistor that is coupled to ferroelectric capacitor 300 by sharing its source/drain terminal with one electrode of ferroelectric capacitor 300 and is used for both READ and WRITE access to ferroelectric capacitor 300.

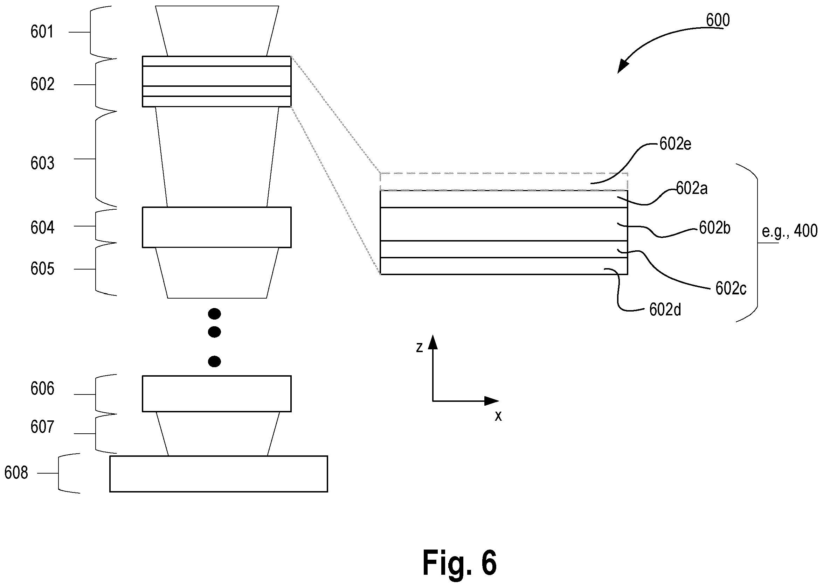

**Fig. 6** illustrates a cross-section 600 of a backend stack having a capacitor 300 or 400 with lattice mismatch between ferroelectric material and metal electrodes, according to some embodiments of the disclosure. In some embodiments, a backend stack of layers includes a layer of metal interconnect (e.g., 601, 604, 606, and 608) and vias (e.g., 603, 605, 607). In some embodiments, one or more of these interconnects (e.g., 601, 604, 606, and 608) can be parallel to one another or orthogonal to one another, in accordance with some embodiments. In some embodiments, all of these interconnects (e.g., 601, 604, 606, and 608) can be parallel to one another. In some embodiments, capacitor 602 can be fabricated between two metal layers, between a metal layer and a via, or between two vias,

In some embodiments, capacitor 602 (e.g., capacitor 300 or 400) is a super capacitor for charge storage. The term "super capacitor", "supercapacitor" and "ultracapacitor" are interchangeable terms. A super capacitor can be used for storing large amounts of charge for providing backup power, regeneration braking storage, peak power assist, and other types of charge/discharge functions.

In some embodiments, capacitor 602 comprises a first conductive layer 602a, a layer 602b comprising FE material (e.g., 303), a second conductive layer 302c, and a conductive seed layer 302d. In some embodiments, first and second conductive layers 302a/c are conductive oxides that include one of the following elements: Sr, Ru, La, Sr, Mn, Nb, Cr, or O. In some embodiments, first and second conductive layers 301a/c are conductive oxides which comprise: $SrRuO_3$, $(La,Sr)CoO_3$ [LSCO], $La_{0.5}Sr_{0.5}Mn_{1-x}Ni_xO$, Cu-doped $SrFe_{0.9}Nb0_{.1}O_3$, $(La,Sr)CrO_3$. In some embodiments, the conductive seed layer 302d comprises $In_2O_3$. In some embodiments, first and second conductive layers 301a/c comprise metals. Examples of such metals include TiN, TaN, Cu, and W.

In some embodiments, layer 602b comprises perovskite (an example of an FE 303 with orthorhombic phase) which is sandwiched between first and second conductive layers 602a/c such that layer 602b is adjacent to first and second conductive layers 602a/c. In some embodiments, layer 602b comprises a low leakage perovskite. Perovskites have cubic structure with a general formula of $ABO_3$, where 'A' includes one of an alkaline earth or rare earth element (e.g., Sr, Bi, Ba, etc.) while 'B' is one of a 3d, 4d, or 5d transition metal element (e.g., Ti, Fe, etc.). In some embodiments, layer 602b includes one of $SrTiO_3$, $BiFeO_3$, $BiTiO_3$, or $BaTiO_3$ with orthorhombic phase.

In some embodiments, layer 602b comprises multiple layers organized in a super lattice where that the FE material has substantially orthorhombic phase. In some embodiments, the super lattice comprises a super lattice of $PbTiO_3$ and $SrTiO_3$; super lattice of $SrZrO_3$ and $BaZrO_3$; $Ca_3B2O_7$, where B is one of Mn or Ti or both; $St_3B_2O_7$, where B is one of Mn or Ti or both; $NaRTiO_4$, where R is one of Y, La, Na, Sm-Ho; super lattice $YFeO_3$ and $YTiO_3$; $AMnO_3$, where A is one of Tb or Y; $Sr_3Zr_2O_7$; and $CdCr_2O_4$. In some embodiments, the thickness of layer 602b along the z-direction is the range of 3 nm (nanometers) to 50 nm.

In some embodiments, seed layer (or starting layer) 602d is deposited first and then layers 602c, 602b, 602a are deposited. In some embodiments, the seed layer 602d is used to template the conductive layer 602c. In some embodiments, a seed layer 602e is deposited in addition to or instead of 602d. In some embodiment seed layer 602d/e includes one of: Ti, Al, Nb, La, or STO ($SrTiO_3$). In some embodiments, seed layer 602d/e includes one of: TiAl, Nb doped STO, or La doped STO.

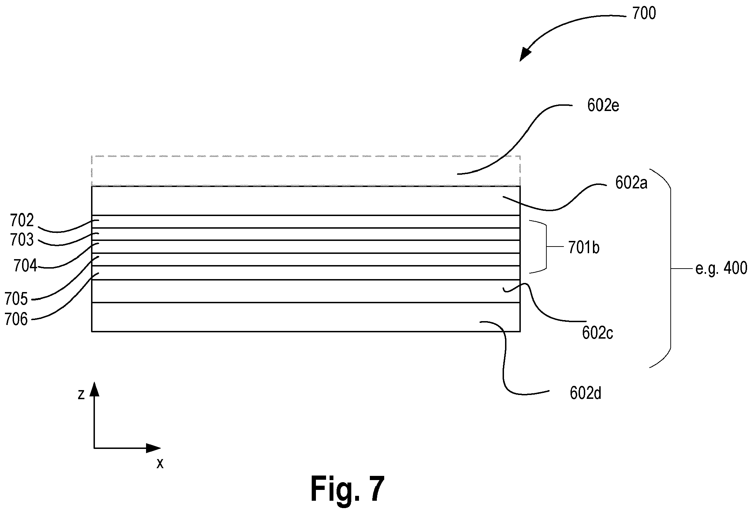

**Fig. 7** illustrates a cross-section of FE capacitor 700 (e.g., 300/400) with lattice mismatch between ferroelectric material and metal electrodes, according to some embodiments of the disclosure. The FE capacitor of **Fig. 7** is similar to the FE capacitor of **Fig. 6** except that perovskite layer 602b is replaced by super lattice 701b. In some embodiments, super lattice 701b includes alternating layers of materials. For example, layer 702 comprises $PbTiO_3$, layer 703 comprises $SrTiO_3$, layer 704 comprises $PbTiO_3$, layer 705 comprises $SrTiO_3$, layer 706 comprises $PbTiO_3$, and so on (e.g., 2 to 100 times). The FE material of the super lattice has substantially orthorhombic phase. In some embodiments, one layer can be a non-polar oxide of the type $(A^{+2}B^{+4}O_3)$ such as $SrZrO_3$, and another layer can be a polar oxide of the type $(A^{+1}B^{+5}O_3$ or $A^{+3}B^{+3}O_3)$ such as $LaAlO_3$ and $LaGaO_3$, where 'A' can comprise one of: La, Sr, Pb, Pr, Nd, Sm, Gd, Y, Tb, Dy, Ho, Er, Tm, Lu, Ce, Li, Na, K, Rb, or Ag, and 'B' can comprise Ga, Al, Sc, In, Ta, Ti, or Zr.

As more alternating layers of $PbTiO_3$ and $SrTiO_3$ are added, FE capacitor can store more charge. In some embodiments, the two or more layers of super lattice 701b have a thickness that extends from the first metal layer 601a to the second metal layer 602c. In some embodiments the thickness is in a range of 2 nm (nanometers) to 100 nm. In some embodiments, the two or more layers of super lattice 701b have a width, which is perpendicular to the thickness, and wherein the width is in a range of 5 nm to 100 nm. In some embodiments, the super lattice is formed with PTO/STO (e.g., repeated 2 to 100 times) for capacitance enhancement. In some embodiments, the super lattice comprises of materials with ferroelectricity (e.g., STO/PTO, $LuFeO_3/LuFe_2O_4$). In some embodiments, the alternating layers of the super lattice are layers of $SrZrO_3$ and $BaZrO_3$. In some embodiments, the alternating layers of the super lattice are layers of $YFeO_3$ and $YTiO_3$.

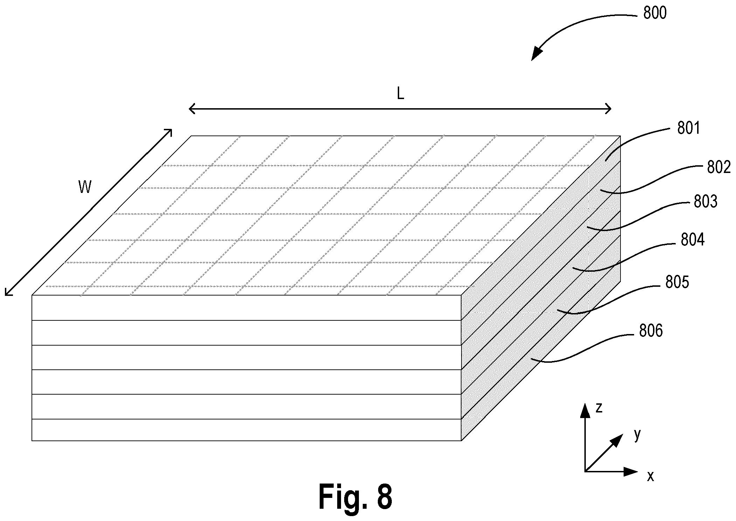

**Fig. 8** illustrates apparatus 800, which includes a power plane comprising a super capacitor with lattice mismatch between ferroelectric material and metal electrodes, according to some embodiments of the disclosure. In some embodiments, apparatus 800 includes power plane 801, dielectric layer 802, layer of magnetic memory 803, dielectric layer 804, ground or sink layer 805. Traditional front-end layer 806 comprises an active region (e.g., a region where a transistor is formed). In some embodiments, power plane 801 provides capacitance such that current or charge delivered by the capacitance is out-of-plane (e.g., perpendicular to the plane of apparatus 800). In some embodiments, by delivering current or charge out-of-plane, high series resistance is avoided in patterned wires (e.g., mesh of wires of power plane 801 shown as dotted lines). In some embodiments, power plane 801 comprises a super capacitor including FE material with orthorhombic phase.

In some embodiments, power plane 801 is disposed "on" or "over" dielectric layer 802 (e.g., oxide). In some embodiments, a beyond CMOS device layer 803 (e.g., layer comprising spin layer, magnetic logic, magnetic memory, magnetic junction (e.g., spin valve or magnetic tunneling junction), all spin logic (ASL), etc.). In some embodiments, beyond CMOS device layer 803 is adjacent to dielectric layer 804. In some embodiments, dielectric layer 804 is adjacent to a ground plane 805. In some embodiments, ground plane 805 is coupled to layer 806, which includes traditional fabricating layers (e.g., layers used in a CMOS process). In some embodiments, the length 'L' and width 'W' of power plane 801 is 1 centimeter (cm) each resulting in a 100 mm$^2$ area plane which is large enough to provide power to a low voltage device beyond CMOS device formed in layer 803. While **Fig. 8** shows layer 801 above layer 803 other orientations are possible. For instance, layer 803 can be above layer 801 or beside layer 801 (e.g., rotating apparatus 800 by 180 or 90 degrees respectively).

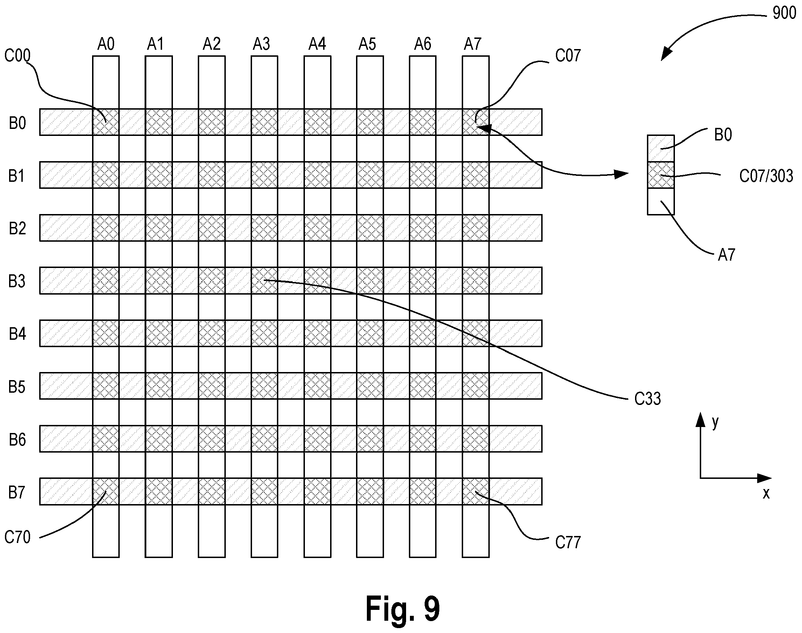

**Fig. 9** illustrates apparatus 900 showing distributed metal-insulator-metal (MIM) capacitors comprising super capacitors with lattice mismatch between ferroelectric material and metal electrodes, according to some embodiments of the disclosure. Apparatus 900 illustrates a mesh of two layers with super capacitor having FE formed between the two layers. In various embodiments, F material here has orthorhombic phase. Here the first layer is layer B having parallel lines B0 through B7, and the second layer is layer A having parallel lines A0 through A7, where lines A0 through A7 are orthogonal to lines B0 through B7. In this example, 8 lines of layers A and B are shown. However, the distributed capacitor of various embodiments can be formed with any number of lines of layers A and B.

In some embodiments, the first layer B with lines B0 through B7 is coupled to a power supply, thus forming power supply lines. In some embodiments, the second layer A with lines A0 through A7 is coupled to a ground supply, thus forming ground supply lines. The array of super capacitors with substantially orthorhombic phase (FE 303) here forms a distributed network of parallel capacitors, in accordance with some embodiments. In some embodiments, super capacitors C00 through C77 (not all are labeled for sake of brevity) are formed between the regions of lines A0 through A7 and B0 through B7. In some embodiments, the super capacitors comprise one of capacitor 300 or 400 (shown as a cross-section).

In some embodiments, the array of super capacitors C00 through C77 is used for charge storage and switching in backend of a computing chip. In some embodiments, the array of super capacitors C00 through C77 is integrated with low voltage logic and is used to provide power to it. In some embodiments, the array of super capacitors C00 through C77 provides power to frontend transistors (e.g., CMOS transistors).

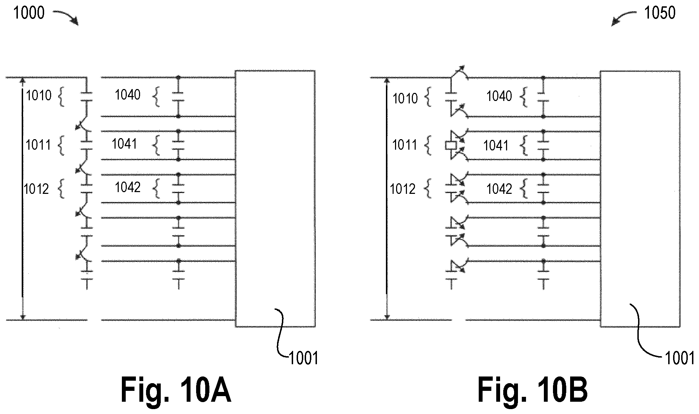

**Figs. 10A-B** illustrate apparatuses 1000 and 1020 and for switch mode power supply during charging and discharging modes, respectively, according to some embodiments of the disclosure. **Fig. 10A** depicts a charge mode configuration in a SMPS (switch mode power supply) and **Fig. 10B** depicts a discharge mode configuration in the power supply, in accordance with some embodiments. Elements 1040, 1041, 1042 represent capacitance (e.g., parasitic capacitance) between layers within the chip, in accordance with some embodiments. In some embodiments, capacitors 1010, 1011, 1012 correspond to orthorhombic phase FE capacitors C00, C01, C02, etc., in accordance with some embodiments. In some embodiments, capacitors 1040, 1041, 1042 and onwards are coupled to power and ground lines of a beyond CMOS device 1001 (e.g., spin logic operating on a 10 mV supply). In some embodiments, during the SMPS charging mode, capacitors 1010, 1011, 1012 are charged in series. As shown in configuration 1050, switching mechanisms (e.g., circuits) may be configured to convert the SMPS from a series to a parallel connection when switching from charge mode to discharge mode, in which capacitors 1010, 1011, 1012 are discharged in parallel.

The series configured charge mode provides for large voltage division and current multiplication, in accordance with some embodiments. For example, a 1 V power supply applied to charge configuration 1000 may be divided down over 100 capacitors to provide 10 mV per capacitor. In place of the charging current of, for example, 1 A (Amperes), each of the capacitors supplies a discharge current of 1 A to create the total current of 100 A over the chip. In some embodiments, the parallel configured discharge mode enables ultra-low series resistance as power need not traverse extended paths and instead deploys out-of-plane directly to a logic device.

In some embodiments, the SMPS includes a charging cycle at, for example, 1 KHz - 10 MHz where a bank of FE capacitors is coupled in series to charge to 1 V (**Fig. 10A**). The FE capacitors here have orthorhombic phase. In some embodiments, the SMPS includes a discharge cycle at 1 KHz - 10 MHz where the capacitors (e.g., each at 10 mV) are discharged in parallel into the device layer. In some embodiments, in order to ensure an uninterrupted power supply, a part of the on-chip capacitors (e.g., C00 through C07) can be in charge mode, while a part of the capacitors (e.g., C10 through C17) can be in discharge mode. Then the SMPS is switched, and charge and discharge modes are reversed. **Figs. 10A-B** illustrate how an entire SMPS is located on a chip along with spin logic devices, spintronic memory, and the like. While the SMPS may cooperate with a battery located off chip, the SMPS itself is located on the chip, in accordance with some embodiments.

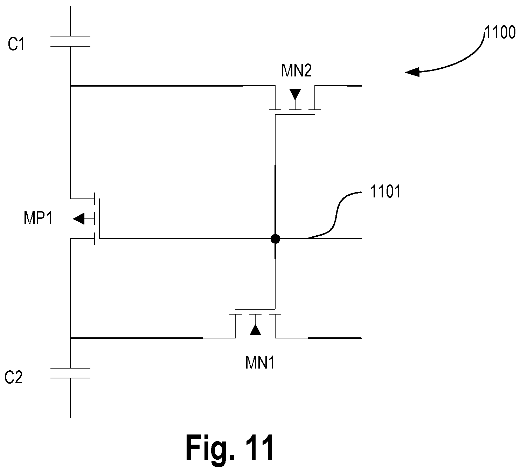

**Fig. 11** illustrates apparatus 1100 comprising a 4-terminal controlled switch for the power plane, according to some embodiments of the disclosure. In some embodiments, the 4-terminal controlled switch comprises p-type transistor MP1, n-type transistors MN1 and MN2, and orthorhombic phase FE capacitors C1 and C2 coupled together as shown. In some embodiments, the gate terminals of transistors MP1, MN1, and MN2 are coupled to node 1101, which provides a switching signal. In some embodiments, capacitors C1 and C2 are according to any one of capacitors 300 or 400.

In some examples, the switching element is part of a SMPS embodiment for converting a 1V, 1A supply to a 10 mV, 100 A supply. In some embodiments, transistor MP1 is operative during a clock phase and transistors MN2 and MN2 are operative in an opposite SMPS clock phase.

Some embodiments include the following capacitance per unit area characteristics to enable a low resistance, low power supply that is operative with beyond CMOS devices (e.g., spin logic devices).

In some embodiments, the total charge (Q) required for a chip having an area A = 1 mm$^2$ with a P$_d$ = 1 W/cm$^2$ power requirement at the spin logic voltage V$_{SL}$ = 0.01 V and SMPS switching frequency is 10 MHz is:

$$Q = \frac{P_d A T_{smps}}{V_{SL}} = 10^{-7} C ,$$

where $T_{smps}$ is the period (inverse frequency) of SMPS switching.

The effective capacitance per unit area at a voltage 0.01 V is thus:

$$C_d = \frac{P_d T_{smps}}{V_{SL}^2} = 10^{-3} F/cm^2 .$$

The required effective capacitance value corresponds to normal capacitance with 10 nm dielectric thickness. An embodiment has a constraint on the dielectric constant, at a dielectric thickness d=10 nm, of:

$$\varepsilon > \frac{C_d d}{\varepsilon_0} = 1.1$$

This is one option for a dielectric constant. A higher dielectric constant will help relax the requirement for the thickness of the layers, requirement on the area occupied by capacitors, or increase the performance of the power plane.

Some embodiments include a fill factor for the power plane at a given dielectric constant, where the fill factor of the power plane is the total area of the power plane used for the MIM capacitors divided by the chip area. Fill factor for the power plane is given by:

$$F = \frac{C_d d}{\varepsilon \varepsilon_0}$$

Hence, the fill factors of the supply plane will leave sufficient space for reuse of the metal layer for regular routing or for via dropping.

Some embodiments include a series resistance whereby series resistance seen by the logic device layer is the source resistance of the SMPS at the output. At a fill factor of 10% the series resistance of the via layer per unit chip area is (via resistivity is assumed 10 times copper resistivity):

$$R_s = \frac{\rho L}{FA} \sim 1.6 X 10^{-12} \Omega / cm^2,$$

where L is length of the via

The effective series resistance voltage drop over the vias is 0.16 nV (which is small compared to the 10 mV supply). At a voltage drop of $V_{drop}$ = 1 mV, the required total conductance of the switches per unit chip area:

$$G_{total} = 3\frac{P_d}{V_{SL}V_{drop}} = 3 \times 10^5 / \left(\Omega \cdot cm^2\right)$$

The power switching transistors (e.g., transistors MP1, MN1, and MN2) are operated at a low resistance region, below the supply voltage $V_{dd}$, where the resistance per unit length of the transistors is less than:

$$G_{STV} = 5\frac{I_{dsat}}{V_{dd}} = 1.4 \times 10^4 / \left(\Omega m\right),$$

where $I_{dsat}$ is taken from the 2011 edition of the International Technology Roadmap for Semiconductors.

In some embodiments, the total conductance of $G_{total}$ requires a gate length per unit area of the chip to be:

$$L_{gtotal} = \frac{G_{total}}{G_{STV}} = \frac{3P_d V_{ds}}{5V_{SL}V_{drop}I_{sat}} = 21m/cm^2$$

Some embodiments may use a total power transistor gate length of 21 meters to power a 100 mm² chip at 1 W/cm² power budget.

In an embodiment the fraction of area of the power transistors (e.g., transistors MP1, MN1, and MN2) is:

$$F_{Ptran} = 4FL_{gtotal} = \frac{12FP_d V_{ds}}{5V_{SL}V_{drop}I_{sat}} = 2.52\%$$

Hence, the area overhead for power gating and conversion is less than 3 %.

In an embodiment, power conversion losses in the SMPS (output delivered power of the SMPS as a fraction of the input power) is as follows:

$$P_{loss} = I_{on}V_{drop} + \frac{C_{Gtotal}V_g^2}{T_{smps}}$$

Or in other words:

$$P_{loss} = \frac{P_d A}{V_{SL}}V_{drop} + \frac{3P_d V_{ds}V_g^2}{5V_{SL}V_{drop}I_{sat}T_{smps}} = 0.141W/cm^2$$

and power efficiency of the SMPS is given by:

$$\eta_{SMPS} = 1 - \frac{P_{loss}}{P_d} = \frac{A}{V_{SL}}V_{drop} + \frac{3V_{ds}V_g^2}{5V_{SL}V_{drop}I_{sat}T_{smps}} = 85.88\%$$

Thus, an embodiment has a power conversion efficiency of 85.88 % with an aerial overhead of 2.5 % (for a high-k dielectric), on state drop of 1 mV, area fill factor of the power plane of 25 %, and current density of 400 A/cm². The series resistance drop is less than 1 nV, thereby avoiding the interconnect losses as outlined in a traditional voltage network.

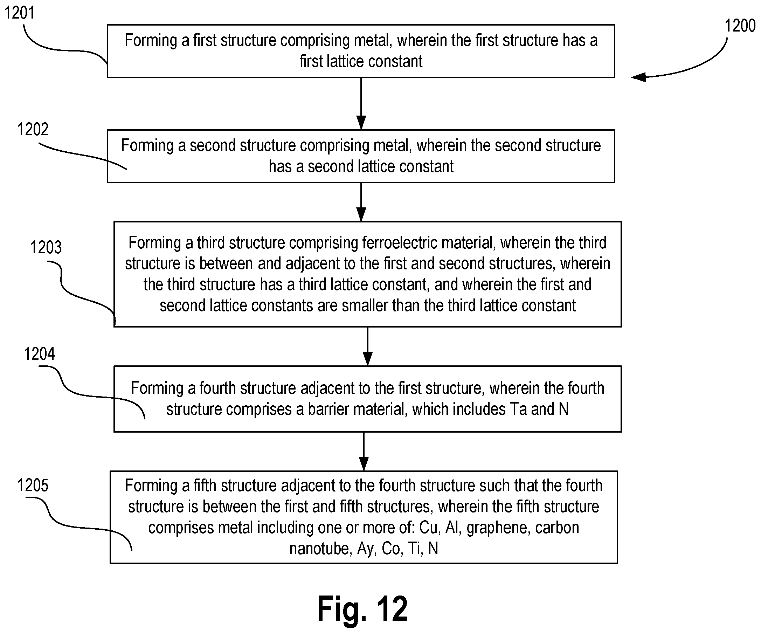

**Fig. 12** illustrates flowchart 1200 of a method for forming an FE capacitor with lattice mismatch between ferroelectric material and metal electrodes, in accordance with some embodiments of the disclosure, in accordance with some embodiments. While the following blocks (or process operations) in the flowchart are arranged in a certain order, the order can be changed. In some embodiments, some blocks can be executed in parallel.

At block 1201, a first structure (e.g., 301) is formed comprising metal, wherein the first structure has a first lattice constant. At block 1202, a second structure (e.g., 302) is formed comprising metal, wherein the second structure has a second lattice constant.

At block 1203, a third structure (e.g., 303) is formed comprising ferroelectric material, wherein the third structure is between and adjacent to the first and second structures, wherein the third structure has a third lattice constant, and wherein the first and second lattice constants are smaller than the third lattice constant. In some embodiments, the first and second lattice constants are smaller than 5 Angstroms. In some embodiments, the ferroelectric material includes one or more of: Hf or Zr. In various embodiments, ferroelectric material has orthorhombic phase. In some embodiments, the ferroelectric material includes an element with lattice constant smaller than 5 Angstroms. In some embodiments, the ferroelectric material includes one or more of: Pb, Ti, Zr, Ba, N Si, La, Al, or Hf. In some embodiments, the ferroelectric material is a super lattice of a first material and a second material, wherein the first material includes one of: PbTiO$_3$ (PTO), SrZrO$_3$, or FeO3, and wherein the second material includes one of: SrTiO$_3$ (STO), BaZrO$_3$, or YTiO$_3$.

At block 1204, a fourth structure (e.g., 305) is formed adjacent to the first structure, wherein the fourth structure comprises a barrier material, which includes Ta and N. At block 1205, a fifth structure (306) is formed adjacent to the fourth structure such that the fourth structure is between the first and fifth structures, wherein the fifth structure comprises metal including one or more of: Cu, Al, graphene, carbon nanotube, Ay, Co, Ti, N.

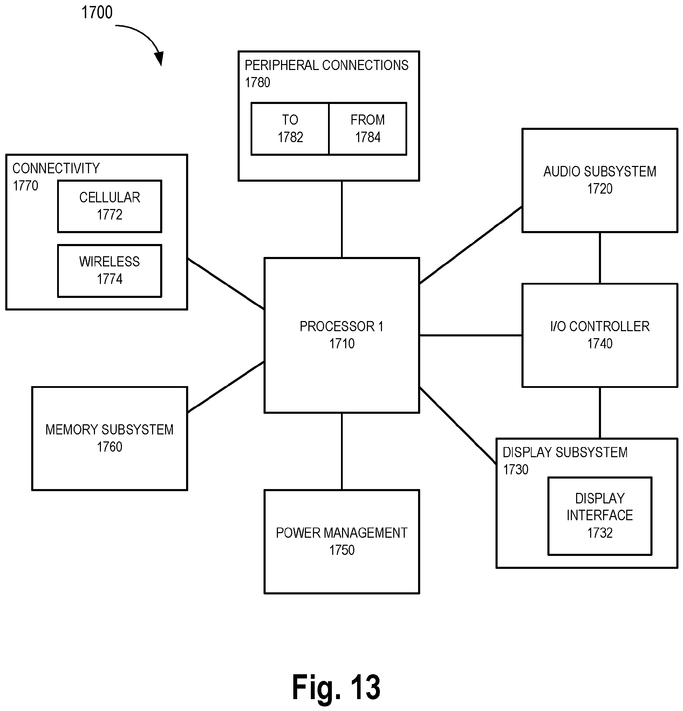

**Fig. 13** illustrates a smart device, a computer system, or a SoC (System-on-Chip) including capacitor with lattice mismatch between ferroelectric material and metal electrodes, in accordance with some embodiments of the disclosure. **Fig. 13** illustrates a block diagram of an embodiment of a mobile device in which flat surface interface connectors could be used. In some embodiments, computing device 1700 represents a mobile computing device, such as a computing tablet, a mobile phone or smart-phone, a wireless-enabled e-reader, or other wireless mobile device. It will be understood that certain components are shown generally, and not all components of such a device are shown in computing device 1700.

In some embodiments, computing device 1700 includes first processor 1710 with capacitor with lattice mismatch between ferroelectric material and metal electrodes, according to some embodiments discussed. Other blocks of the computing device 1700 may also include capacitor with lattice mismatch between ferroelectric material and metal electrodes, according to some embodiments. The various embodiments of the present disclosure may also comprise a network interface within 1770 such as a wireless interface so that a system embodiment may be incorporated into a wireless device, for example, cell phone or personal digital assistant. Capacitor 300 or 400 is formed with lattice mismatch between ferroelectric material 303 and metal electrodes 301 and 302.

In some embodiments, processor 1710 can include one or more physical devices, such as microprocessors, application processors, microcontrollers, programmable logic devices, or other processing means. The processing operations performed by processor 1710 include the execution of an operating platform or operating system on which applications and/or device functions are executed. The processing operations include operations related to I/O (input/output) with a human user or with other devices, operations related to power management, and/or operations related to connecting the computing device 1700 to another device. The processing operations may also include operations related to audio I/O and/or display I/O.

In some embodiments, computing device 1700 includes audio subsystem 1720, which represents hardware (e.g., audio hardware and audio circuits) and software (e.g., drivers, codecs) components associated with providing audio functions to the computing device. Audio functions can include speaker and/or headphone output, as well as microphone input. Devices for such functions can be integrated into computing device 1700, or connected to the computing device 1700. In one embodiment, a user interacts with the computing device 1700 by providing audio commands that are received and processed by processor 1710.

In some embodiments, computing device 1700 comprises display subsystem 1730. Display subsystem 1730 represents hardware (e.g., display devices) and software (e.g., drivers) components that provide a visual and/or tactile display for a user to interact with the computing device 1700. Display subsystem 1730 includes display interface 1732, which includes the particular screen or hardware device used to provide a display to a user. In one embodiment, display interface 1732 includes logic separate from processor 1710 to perform at least some processing related to the display. In one embodiment, display subsystem 1730 includes a touch screen (or touch pad) device that provides both output and input to a user.

In some embodiments, computing device 1700 comprises I/O controller 1740. I/O controller 1740 represents hardware devices and software components related to interaction with a user. I/O controller 1740 is operable to manage hardware that is part of audio subsystem 1720 and/or display subsystem 1730. Additionally, I/O controller 1740 illustrates a connection point for additional devices that connect to computing device 1700 through which a user might interact with the system. For example, devices that can be attached to the computing device 1700 might include microphone devices, speaker or stereo systems, video systems or other display devices, keyboard or keypad devices, or other I/O devices for use with specific applications such as card readers or other devices.

As mentioned above, I/O controller 1740 can interact with audio subsystem 1720 and/or display subsystem 1730. For example, input through a microphone or other audio device can provide input or commands for one or more applications or functions of the computing device 1700. Additionally, audio output can be provided instead of, or in addition to display output. In another example, if display subsystem 1730 includes a touch screen, the display device also acts as an input device, which can be at least partially managed by I/O controller 1740. There can also be additional buttons or switches on the computing device 1700 to provide I/O functions managed by I/O controller 1740.

In some embodiments, I/O controller 1740 manages devices such as accelerometers, cameras, light sensors or other environmental sensors, or other hardware that can be included in the computing device 1700. The input can be part of direct user interaction, as well as providing environmental input to the system to influence its operations (such as filtering for noise, adjusting displays for brightness detection, applying a flash for a camera, or other features).

In some embodiments, computing device 1700 includes power management 1750 that manages battery power usage, charging of the battery, and features related to power saving operation. Memory subsystem 1760 includes memory devices for storing information in computing device 1700. Memory can include nonvolatile (state does not change if power to the memory device is interrupted) and/or volatile (state is indeterminate if power to the memory device is interrupted) memory devices. Memory subsystem 1760 can store application data, user data, music, photos, documents, or other data, as well as system data (whether long-term or temporary) related to the execution of the applications and functions of the computing device 1700.

Elements of embodiments are also provided as a machine-readable medium (e.g., memory 1760) for storing the computer-executable instructions (e.g., instructions to implement any other processes discussed herein). The machine-readable medium (e.g., memory 1760) may include, but is not limited to, flash memory, optical disks, CD-ROMs, DVD ROMs, RAMs, EPROMs, EEPROMs, magnetic or optical cards, phase change memory (PCM), or other types of machine-readable media suitable for storing electronic or computer-executable instructions. For example, embodiments of the disclosure may be downloaded as a computer program (e.g., BIOS) which may be transferred from a remote computer (e.g., a server) to a requesting computer (e.g., a client) by way of data signals via a communication link (e.g., a modem or network connection).

In some embodiments, computing device 1700 comprises connectivity 1770. Connectivity 1770 includes hardware devices (e.g., wireless and/or wired connectors and communication hardware) and software components (e.g., drivers, protocol stacks) to enable the computing device 1700 to communicate with external devices. The computing device 1700 could be separate devices, such as other computing devices, wireless access points or base stations, as well as peripherals such as headsets, printers, or other devices.

Connectivity 1770 can include multiple different types of connectivity. To generalize, the computing device 1700 is illustrated with cellular connectivity 1772 and wireless connectivity 1774. Cellular connectivity 1772 refers generally to cellular network connectivity provided by wireless carriers, such as provided via GSM (global system for mobile communications) or variations or derivatives, CDMA (code division multiple access) or variations or derivatives, TDM (time division multiplexing) or variations or derivatives, or other cellular service standards. Wireless connectivity (or wireless interface) 1774 refers to wireless connectivity that is not cellular, and can include personal area networks (such as Bluetooth, Near Field, etc.), local area networks (such as Wi-Fi), and/or wide area networks (such as WiMax), or other wireless communication.

In some embodiments, computing device 1700 comprises peripheral connections 1780. Peripheral connections 1780 include hardware interfaces and connectors, as well as software components (e.g., drivers, protocol stacks) to make peripheral connections. It will be understood that the computing device 1700 could both be a peripheral device ("to" 1782) to other computing devices, as well as have peripheral devices ("from" 1784) connected to it. The computing device 1700 commonly has a "docking" connector to connect to other computing devices for purposes such as managing (e.g., downloading and/or uploading, changing, synchronizing) content on computing device 1700. Additionally, a docking connector can allow computing device 1700 to connect to certain peripherals that allow the computing device 1700 to control content output, for example, to audiovisual or other systems.

In addition to a proprietary docking connector or other proprietary connection hardware, the computing device 1700 can make peripheral connections 1780 via common or standards-based connectors. Common types can include a Universal Serial Bus (USB) connector (which can include any of a number of different hardware interfaces), DisplayPort including MiniDisplayPort (MDP), High Definition Multimedia Interface (HDMI), Firewire, or other types.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional element.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth in order to describe example embodiments of the disclosure, it should be apparent to one skilled in the art that the disclosure can be practiced without, or with variation of, these specific details. The description is thus to be regarded as illustrative instead of limiting.

The following examples are provided to illustrate various embodiments. These examples can be combined with other examples in any suitable manner.

Example 1: An apparatus comprising: a first structure comprising metal, wherein the first structure has a first lattice constant; a second structure comprising metal, wherein the second structure has a second lattice constant; and a third structure comprising ferroelectric material, wherein the third structure is between and adjacent to the first and second structures, wherein the third structure has a third lattice constant, and wherein the first and second lattice constants are smaller than the third lattice constant.

Example 2: The apparatus of example 1 comprising a fourth structure adjacent to the first structure, wherein the fourth structure comprises a barrier material, which includes Ta and N.

Example 3: The apparatus of example 1 comprising a fifth structure adjacent to the fourth structure such that the fourth structure is between the first and fifth structures, wherein the fifth structure comprises metal including one or more of: Cu, Al, graphene, carbon nanotube, Ay, Co, Ti, N.

Example 4: The apparatus of example 1, wherein the first and second lattice constants are smaller than 5 Angstroms.

Example 5: The apparatus of example 1, wherein the ferroelectric material includes one or more of: Hf or Zr.

Example 6: The apparatus of example 1, wherein the ferroelectric material includes an element with lattice constant smaller than 5 Angstroms.

Example 7: The apparatus of claim 1, wherein the ferroelectric material includes one or more of: Pb, Ti, Zr, Ba, N Si, La, Al, or Hf.

Example 8: The apparatus of example 1, wherein the ferroelectric material is a super lattice of a first material and a second material, wherein the first material includes one of: $PbTiO_3$ (PTO), $SrZrO_3$, or FeO3, and wherein the second material includes one of: $SrTiO_3$ (STO), $BaZrO_3$, or $YTiO_3$.

Example 9: An apparatus comprising: a bit-line; a word-line; a transistor coupled to the bit-line and the word-line; and a capacitor over the bit-line (COB), wherein the COB is coupled to ground and the transistor, wherein the COB comprises: a first electrode comprising metal, wherein the first structure has a first lattice constant; a second electrode comprising metal, wherein the second structure has a second lattice constant; and a structure comprising ferroelectric material, wherein the structure is between and adjacent to the first and second electrodes, wherein the structure has a third lattice constant, and wherein the first and second lattice constants are smaller than the third lattice constant.

Example 10: The apparatus of example 9 comprising: a first barrier structure adjacent to the first electrode, wherein the second barrier structure comprises Ta and N; and a second barrier structure adjacent to the second electrode, wherein the second barrier structure comprises Ta and N.

Example 11: The apparatus of example 9, wherein the ferroelectric material has orthorhombic phase.

Example 12: The apparatus of example 10 comprising a first interconnect adjacent to the first barrier; and a second interconnect adjacent to the second barrier.

Example 13: The apparatus of example 12, wherein the first and second interconnect comprise metal including one or more of: Cu, Al, graphene, carbon nanotube, Ay, Co, Ti, or N.

Example 14: The apparatus of example 9, wherein the first and second lattice constants are smaller than 5 Angstroms.

Example 15: The apparatus of example 9, wherein the ferroelectric material includes one or more of: Hf or Zr.

Example 16: The apparatus of example 9, wherein the ferroelectric material includes an element with lattice constant smaller than 5 Angstroms.

Example 17: A system comprising: a processor; a memory coupled to the processor, wherein the memory includes a ferroelectric material between two electrodes, wherein a lattice constant of the two electrodes is smaller than a lattice constant of the ferroelectric material; and a wireless interface to allow the processor to communicate with another device.

Example 18: The system of example 17, wherein the two electrodes comprise metal including one or more of: Cu, Al, graphene, carbon nanotube, Ay, Co, Ti, or N.

Example 19: The system of example 17, wherein the lattice constants of the two electrodes are smaller than 5 Angstroms.

Example 20: The system of example 17, wherein the ferroelectric material includes oxides of one or more of: Hf or Zr.

An abstract is provided that will allow the reader to ascertain the nature and gist of the technical disclosure. The abstract is submitted with the understanding that it will not be used to limit the scope or meaning of the claims. The following claims are hereby incorporated into the detailed description, with each claim standing on its own as a separate embodiment.

**Claims**

1. An apparatus comprising:

   a first structure comprising metal, wherein the first structure has a first lattice constant;
   a second structure comprising metal, wherein the second structure has a second lattice constant; and
   a third structure comprising ferroelectric material, wherein the third structure is between and adjacent to the first and second structures, wherein the third structure has a third lattice constant, and wherein the first and second lattice constants are smaller than the third lattice constant.

2. The apparatus of claim 1 comprising a fourth structure adjacent to the first structure, wherein the fourth structure comprises a barrier material, which includes Ta and N.

3. The apparatus of claim 1 comprising a fifth structure adjacent to the fourth structure such that the fourth structure is between the first and fifth structures, wherein the fifth structure comprises metal including one or more of: Cu, Al, graphene, carbon nanotube, Ay, Co, Ti, or N.

4. The apparatus according to any one of claims 1 to 3, wherein the first and second lattice constants are smaller than 5 Angstroms.

**5.** The apparatus of claim 1, wherein the ferroelectric material includes one or more of: Hf or Zr.

**6.** The apparatus of claim 1, wherein the ferroelectric material includes an element with lattice constant smaller than 5 Angstroms.

**7.** The apparatus of claim 1, wherein the ferroelectric material includes one or more of: Pb, Ti, Zr, Ba, N Si, La, Al, or Hf.

**8.** The apparatus of claim 1, wherein the ferroelectric material is a super lattice of a first material and a second material, wherein the first material includes one of: $PbTiO_3$ (PTO), $SrZrO_3$, or FeO3, and wherein the second material includes one of: $SrTiO_3$ (STO), $BaZrO_3$, or $YTiO_3$.

**9.** A system comprising:

a processor;
a memory coupled to the processor, wherein the memory includes a ferroelectric material between two electrodes, wherein a lattice constant of the two electrodes is smaller than a lattice constant of the ferroelectric material; and
a wireless interface to allow the processor to communicate with another device.

**10.** The system of claim 9, wherein the two electrodes comprise metal including one or more of: Cu, Al, graphene, carbon nanotube, Ay, Co, Ti, or N.

**11.** The system of claim 9, wherein the lattice constants of the two electrodes are smaller than 5 Angstroms.

**12.** The system according to any one of claims 9 to 11, wherein the ferroelectric material includes oxides of one or more of: Hf or Zr.

**13.** A method comprising:

forming a first structure comprising metal, wherein the first structure has a first lattice constant;
forming a second structure comprising metal, wherein the second structure has a second lattice constant; and
forming a third structure comprising ferroelectric material, wherein the third structure is between and adjacent to the first and second structures, wherein the third structure has a third lattice constant, and wherein the first and second lattice constants are smaller than the third lattice constant.

**14.** The method of claim 13 comprising:

forming a fourth structure adjacent to the first structure, wherein the fourth structure comprises a barrier material, which includes Ta and N.
forming a fifth structure adjacent to the fourth structure such that the fourth structure is between the first and fifth structures, wherein the fifth structure comprises metal including one or more of: Cu, Al, graphene, carbon nanotube, Ay, Co, Ti, or N.

**15.** The method of claim 13, wherein:

the first and second lattice constants are smaller than 5 Angstroms;
the ferroelectric material includes one or more of: Hf or Zr;
the ferroelectric material includes an element with lattice constant smaller than 5 Angstroms; or
the ferroelectric material includes one or more of: Pb, Ti, Zr, Ba, N Si, La, Al, or Hf; or wherein the ferroelectric material is a super lattice of a first material and a second material, wherein the first material includes one of: $PbTiO_3$ (PTO), $SrZrO_3$, or FeO3, and wherein the second material includes one of: $SrTiO_3$ (STO), $BaZrO_3$, or $YTiO_3$.

Fig. 1A

Fig. 1B

Fig. 1C

EP 3 706 167 A1

16

**Fig. 2**

EP 3 706 167 A1

**Fig. 3**

400 (e.g., 100)

307

305

308

306

402 (e.g., 102)

303

401 (e.g., 101)

t3

t1

t2

x

z

**Fig. 4**

Fig. 5

EP 3 706 167 A1

**Fig. 6**

EP 3 706 167 A1

**Fig. 7**

**Fig. 8**

**Fig. 9**

Fig. 10A

Fig. 10B

1100

1101

MN2

MN1

MP1

C1

C2

**Fig. 11**

1201

1200

Forming a first structure comprising metal, wherein the first structure has a first lattice constant

1202

Forming a second structure comprising metal, wherein the second structure has a second lattice constant

1203

Forming a third structure comprising ferroelectric material, wherein the third structure is between and adjacent to the first and second structures, wherein the third structure has a third lattice constant, and wherein the first and second lattice constants are smaller than the third lattice constant

1204

Forming a fourth structure adjacent to the first structure, wherein the fourth structure comprises a barrier material, which includes Ta and N

1205

Forming a fifth structure adjacent to the fourth structure such that the fourth structure is between the first and fifth structures, wherein the fifth structure comprises metal including one or more of: Cu, Al, graphene, carbon nanotube, Ay, Co, Ti, N

**Fig. 12**

1700

**Fig. 13**

Europäisches
Patentamt

European
Patent Office

Office européen
des brevets

# EUROPEAN SEARCH REPORT

Application Number

EP 20 15 3095

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/273366 A1 (KO HWA-YOUNG [KR] ET AL) 7 December 2006 (2006-12-07) * paragraphs [0068] - [0089]; figures 4A-4E * | 1-7, 13-15 | INV. H01L27/11507 H01L49/02 H01G4/005 H01G4/33 |
| X | US 6 051 858 A (UCHIDA HIROTO [US] ET AL) 18 April 2000 (2000-04-18) * column 14, line 11 - column 21, line 10; figure 20 * | 1,8,13 | |
| X | US 2002/006674 A1 (MA SHAWMING [US] ET AL) 17 January 2002 (2002-01-17) * paragraphs [0034] - [0036]; figure 1 * | 1,9-13 | |

TECHNICAL FIELDS
SEARCHED      (IPC)

H01L

The present search report has been drawn up for all claims

| Place of search | Date of completion of the search | Examiner |
|---|---|---|
| Munich | 14 July 2020 | Bräckelmann, Gregor |

EPO FORM 1503 03.82 (P04C01)

## ANNEX TO THE EUROPEAN SEARCH REPORT
## ON EUROPEAN PATENT APPLICATION NO.

EP 20 15 3095

This annex lists the patent family members relating to the patent documents cited in the above-mentioned European search report.
The members are as contained in the European Patent Office EDP file on
The European Patent Office is in no way liable for these particulars which are merely given for the purpose of information.

14-07-2020

| Patent document cited in search report | | | Publication date | Patent family member(s) | | | Publication date |
|---|---|---|---|---|---|---|---|
| US | 2006273366 | A1 | 07-12-2006 | JP<br>KR<br>US | 2006344929<br>20060127507<br>2006273366 | A<br>A<br>A1 | 21-12-2006<br>13-12-2006<br>07-12-2006 |
| US | 6051858 | A | 18-04-2000 | JP<br>KR<br>US | H113977<br>980012467<br>6051858 | A<br>A<br>A | 06-01-1999<br>30-04-1998<br>18-04-2000 |
| US | 2002006674 | A1 | 17-01-2002 | JP<br>US | 2001230382<br>2002006674 | A<br>A1 | 24-08-2001<br>17-01-2002 |

EPO FORM P0459

For more details about this annex : see Official Journal of the European Patent Office, No. 12/82